# EUROPEAN PATENT APPLICATION

(11) **EP 1 182 913 A1**
(43) Date of publication of application: **27.02.2002**
(21) Application number: 01305349.1
(22) Date of filing: 20.06.2001
(51) Int. Cl.: H05K 1/02, H05K 9/00, H01R 12/16

(54) **High speed circuit board interconnection**

(30) Priority: 25.08.2000 US 648165
(71) Applicant: Agere Systems Guardian Corporation, Orlando, Florida 32819 (US)
(72) Inventor: Bosch, Fridolin Ludwig, Bethlehem, Lehigh County, Pennsylvania (US); Fu, Hui, Allentown, Pennsylvania 18104 (US); Karnacewicz, Mark, Norristown, Pennsylvania 19403 (US); O'Neill, Steven P, Allentown, Pennsylvania 18104 (US)
(74) Representative: Williams, David John

(57) **Abstract**

The invention is a device which includes at least one circuit board (12) having major surfaces (13, 14) with a signal pin hole (31), a ground pin hole (32), and a pattern of via holes (34-37) extending between the surfaces. The via holes surround the signal pin hole and are electrically connected to a DC ground plane (15) formed in the board. A ground pin (16) and signal pin (17) are mounted within the ground pin hole and signal pin hole, respectively, and extend past at least one of the surfaces. In one embodiment, a conductive shield (18) surrounds at least a portion of the signal pin extending past the surface. In another embodiment, the shield can be omitted.

## Description

### Field of the Invention

This invention relates to electrical connection between circuit boards.

### Background of the Invention

Many systems require a high speed connection between circuit boards carrying semiconductor components. For example, in certain optical transmission systems, the transmitters and/or receivers include more than one multilayer circuit board which need to be interconnected. This interconnection desirably provides the capacity to handle signals from DC to greater than 12 GHz. At the present time, these interconnections are usually established with the use of coaxial or surface mount techniques. While adequate, such interconnects add cost and complexity.

Therefore, there is a need in the art for providing low cost, high speed electrical interconnection between circuit boards. Desirably, the interconnection should exhibit low conduction, reflection, and radiation losses.

### Summary of the Invention

The invention is a device which includes at least one circuit board having major surfaces with a signal pin hole, a ground pin hole, and a pattern of via holes extending between the surfaces. The via holes surround the signal pin hole and are electrically connected to a DC ground plane formed in the board. A ground pin and signal pin are mounted within the ground pin hole and signal pin hole, respectively, and extend past at least one of the surfaces. In one embodiment, a conductive shield surrounds at least a portion of the signal pin extending past the surface. In another embodiment, the shield can be omitted.

### Brief Description of the Figures

These and other features of the invention are delineated in detail in the following description. In the drawing:
Fig 1 is a perspective view of a pair of circuit boards connected according to one embodiment of the invention with a portion of the boards cut-away to reveal the electrical interconnection;
Fig 2 is a cross sectional view along line 2-2 of Fig. 1 showing a portion of a board according to the same embodiment;
Fig 3 is a plan view of a portion of a board according to the same embodiment;
Fig 4 is a graph illustrating return loss characteristics of circuit boards connected in accordance with the same embodiment;
Fig 5 is a graph illustrating insertion loss characteristics of circuit boards connected in accordance with the same embodiment;
Fig 6 is a graph illustrating return loss characteristics of circuit boards connected in accordance with another embodiment of the invention;
Fig 7 is a graph illustrating insertion loss characteristics of circuit boards connected in accordance with the said another embodiment of the invention.
Fig. 8 is a cross-sectional view of a further portion of the board of Figs. 1-3; and
Fig. 9 is a perspective view of an interconnect module between the boards in accordance with one embodiment.

It will be appreciated that, for purposes of illustration, these figures are not necessarily drawn to scale.

### Detailed Description

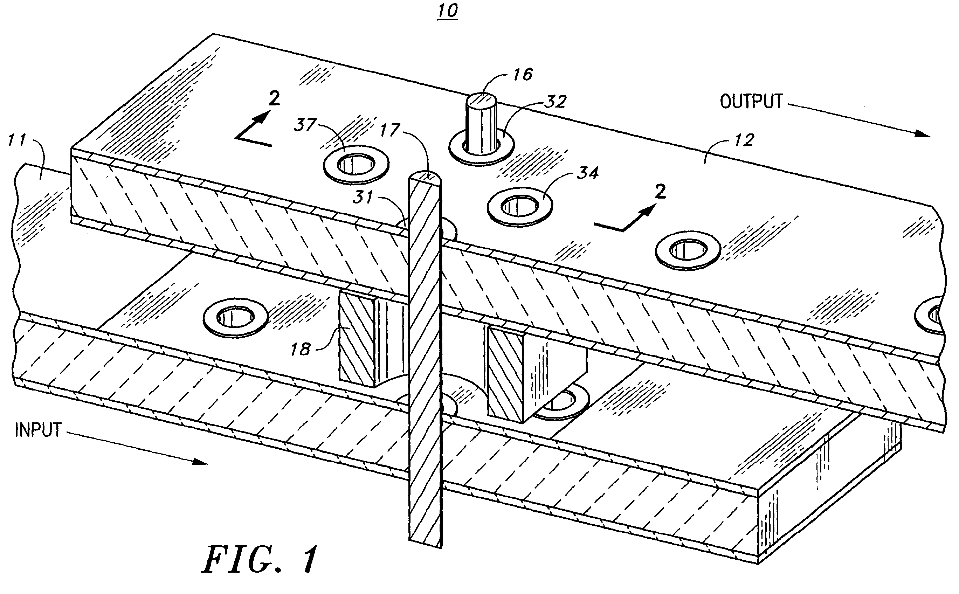

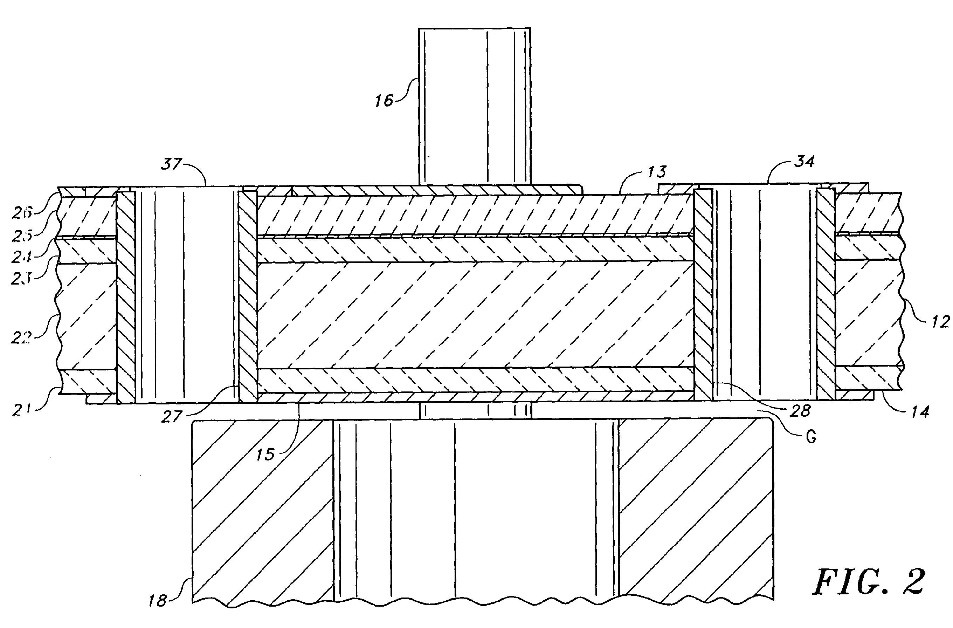

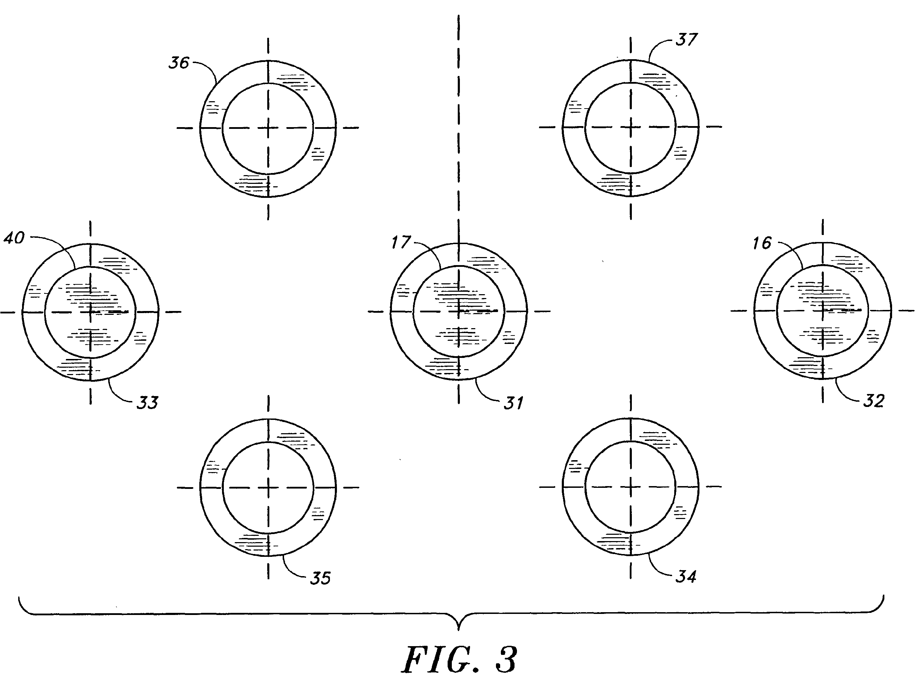

Figs 1-3 illustrate an embodiment of the invention in different views. The interconnection device, 10, includes at least a first circuit board, 11, which may be electrically coupled to a second circuit board, 12. Each board includes a signal pin hole, 31, at least one, and preferably two ground pin holes, 32 and 33, and a pattern of via holes, e.g., 34-37, extending between major surfaces, 13 and 14, of the board. As illustrated in Fig 3, the via holes, 34-37, surround the signal pin hole, 31, and, as illustrated in Fig 2, are electrically connected to a DC ground plane, 15, preferably formed on one of the surfaces, 14, of the board. At least one, and preferably two ground pins, 16 and 40, are mounted within corresponding ground holes 32 and 33, and at least one signal pin, 17, is mounted within a corresponding signal hole, 31. The ground pins and signal pin extend past the surface of the board so that they can be inserted in corresponding holes in the first circuit board, 11. A conductive shield, 18, surrounds at least a portion of the signal pin, 17, extending past the surface, 14, of the board, 11 in one embodiment. In another embodiment, the shield, 18, may be omitted.

In more detail, each circuit board, e.g., 11, is preferably a multi-layer board of various conductive and ceramic layers designed to conduct signals in the range DC to 12 GHz and possibly to 14 GHz. For example, the scheme illustrated in Fig 1 conducts signals from the top side of board, 11, through the signal pin, 17, to the top side, 13, of board, 12, as indicated by the arrows designated "input" and "output". While, in this embodiment, it is assumed that the two boards are identical, this need not be the case. Further, the boards do not have to be multilayered as long as they include the key elements discussed herein.

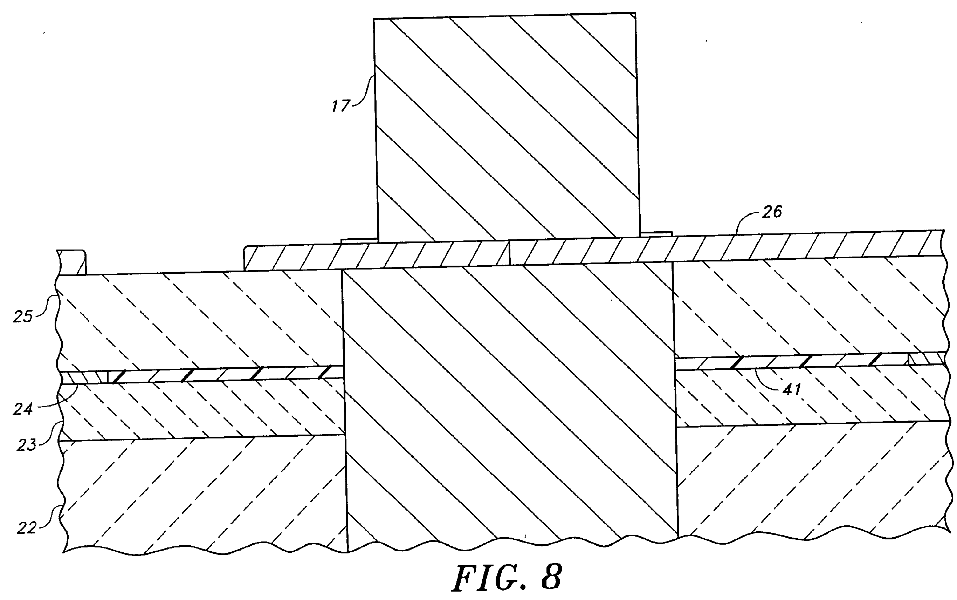

As illustrated in Fig 2, the board,12, starting from the bottom surface, 14, includes a DC ground plane layer, 15, which is typically formed on the bottom surface and comprises a metal such as gold. While this layer is preferably on the bottom surface, it may be covered by other layers if desired. Next is a pre-preg ceramic layer, 21, which serves as an adhesive for the layer, 15, and a layer, 22, which is also a ceramic material and serves as a substrate and through which DC signals may be propagated in some areas outside that shown in Fig 2. Formed on top of the layer, 22, is another pre-preg layer, 23, which also serves as an adhesive layer. Formed on layer 23, is a thin layer, 24, of conductive material such as gold which serves as an RF ground plane for a microstrip transmitter. The signal pin 17 preferably is electrically insulated from the RF ground plane, 24. For example, a circular slot, 41, of Fig. 8, of approximately .030 inches around the signal pin, 17, can give optimal RF performance, with a preferred diameter in the range .025 - .050 inches. The top most ceramic layer, 25, is a low-loss, non-dispersive material for propagating RF signals up to at least 12 GHz such as Rogers 4350™. The top layer, 26, is a material such as gold which conducts the RF signal.

The via holes, 34-37, two of which (34 and 37) are illustrated in Fig 2, are formed through the layers of the board by standard techniques such as drilling. As known in the art, via holes include conductive material, 27 and 28, filling the holes or deposited on the sidewalls of the holes to provide electrical connection between selected layers of the board. In this example, the conductive material is deposited on the sidewalls of the vias, and all vias are electrically connected to the DC ground plane, 15, and to the RF ground plane, 24, while being electrically insulated from the remaining layers. The DC ground plane, 15, in turn, is electrically connected to the ground pins, 16 and 40. The signal pin, 17, is electrically connected to the RF layer, 25, and insulated from the other layers.

In a presently preferred embodiment for operation of a 10 GHz optical transmitter, the diameter of the via holes, 34-37, is within the range .020 to .026, and most preferably .023 inches (584 microns). Preferably at least four vias surround the signal pin forming a square pattern as shown, but any additional number of vias may be employed. The center-to-center spacing of the vias is preferably within the range .090 to .110, and most desirably 0.1 inch (254 microns). The center-to-center horizontal spacing of the vias, 34 and 37, from the signal hole, 31, is preferably within the range 0.45 to 0.55 inches, and most preferably, .050 inches (127 microns). The center-to-center horizontal spacing of the ground hole, 32, from the signal hole, 31, is preferably within the range .090 to .110, and most preferably 0.100 inches (254 microns).

The shield, 18, may be any conductive material, preferably gold-plated aluminum. The shield may be insulated from the signal pin, 17, by air or other suitable dielectric. It will be noted that the shield, 18, is preferably separated from the DC ground plane, 15, of the board, 12, by a gap, g. This gap is advantageous for greater manufacturing tolerances. Preferably, the pins, 16, 17, and 40, are soldered to the boards, 11 and 12, and the shield, 18, need not be soldered.

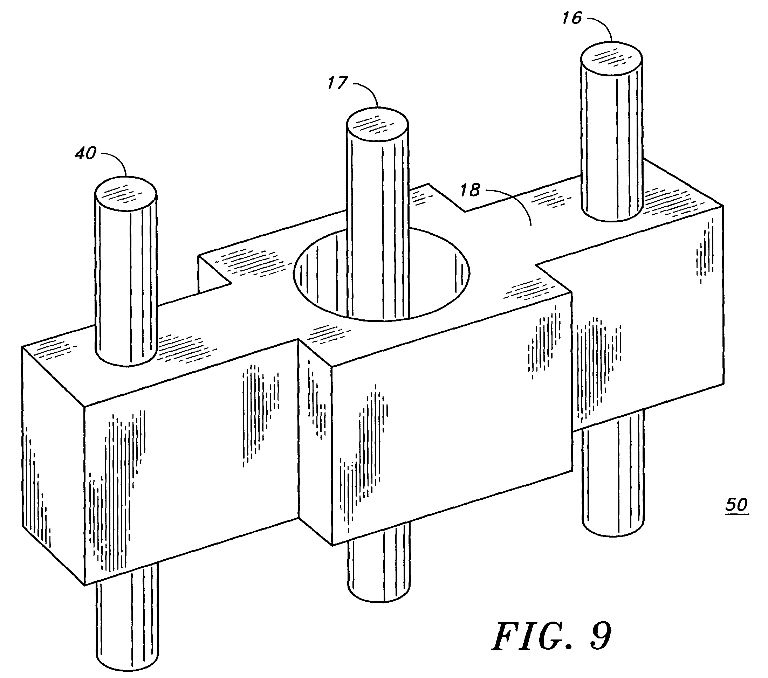

It will be noted that one of the advantages of the invention is the fact that inexpensive signal, 17, and ground pins, 16 and 40, extend from holes in one board to corresponding holes in the other board. There is no need for expensive connectors which require a male and female part between the boards. The signal and ground pins with the surrounding shield, 18, can be provided as a separate interconnect module, 50 of Fig. 9, where the ends of the pins are plugged into their respective holes in the two boards. The interconnect module may be mounted to one of the boards, e.g., 11, and the combination sold to customers who then mount the opposite end of the pins to their board, 12.

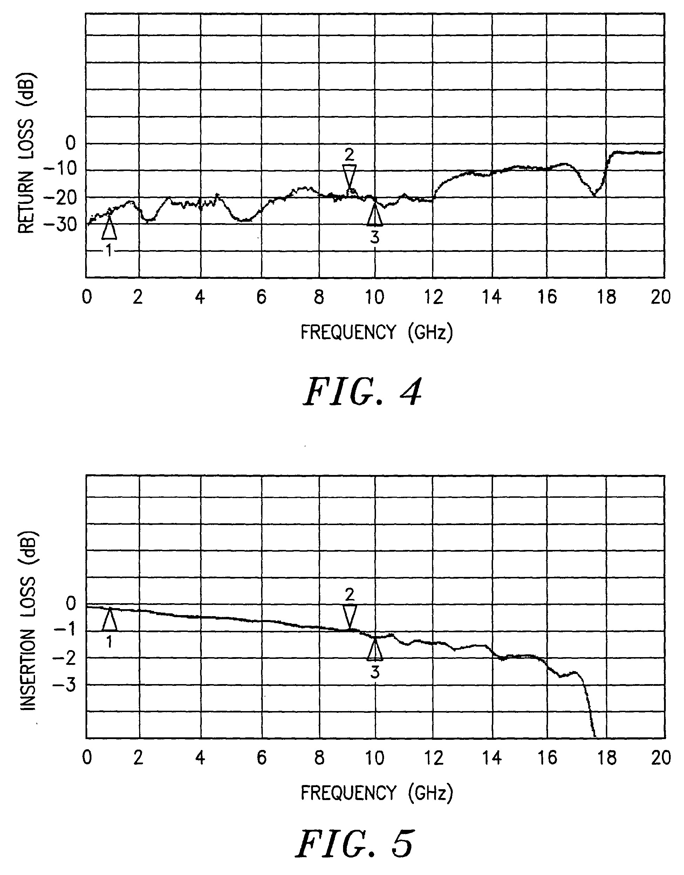

As illustrated in Figs 4 and 5, connections fabricated according to the above-described embodiment exhibit excellent return loss and insertion loss characteristics up to as high as 12 GHz. For example, measuring from the input of board 11 to the output of board 12, marker 3 shows a return loss of approximately -20 dB and an insertion loss of -1 dB at 10 GHz. Approximately 80% of the insertion loss is due to conductor and dielectric losses in the boards 11 and 12, each of which measured 0.8 inches in length. The remaining 20% is due to conductor and reflection losses from one end of pin 17 to the other. This performance is comparable to that using more expensive SMA connectors. Preferably, the return loss will be at least -15 dB and the insertion loss will be no greater than -1.8 dB at 10 GHz including input and output board losses.

Applicants have also discovered that if the boards, 11 and 12, are spaced close together, the shield, 18, may be eliminated, thereby further reducing the cost of the connection. It appears that an interconnection without a shield can operate at frequencies up to 10 GHz if the spacing of the boards is .1 inches (254 microns) or less.

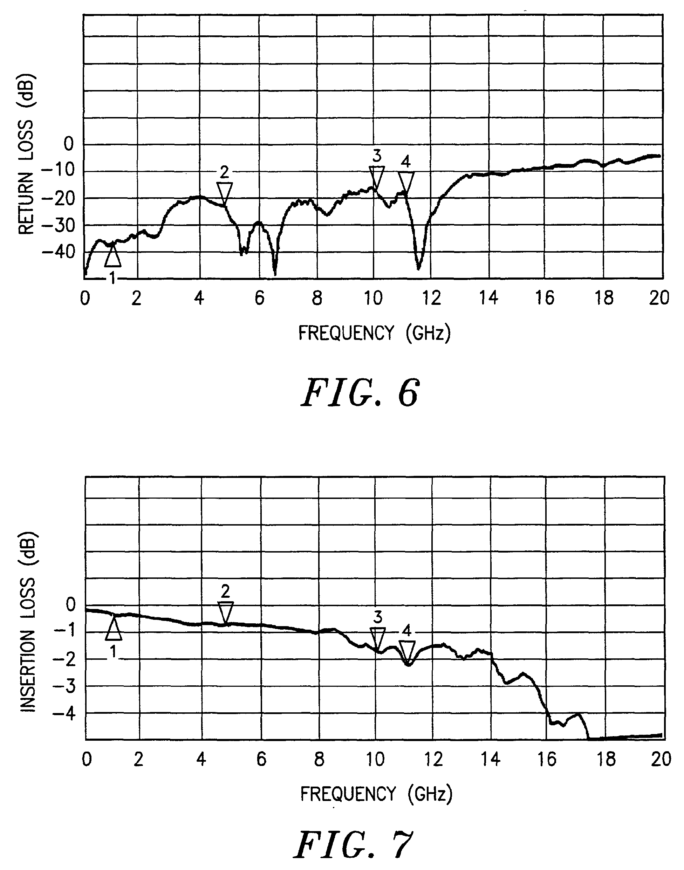

Figs 6 and 7 illustrate return loss and insertion loss characteristics, respectively for a device which includes the same via hole and pin configuration as Figs 1-3, but without the shield surrounding the signal pin. It will be noted, for example, that the return loss at 10 GHz was approximately -16 dB, and the insertion loss was approximately -1.4 dB, which parameters are well within the desired values.

Various modifications of the invention as described will become apparent to those skilled in the art. For example, although four via holes are shown, it may be possible to use only two via holes, e.g., 35 and 37, diagonally across from the signal pin, 17. While two ground pins are preferred for symmetry, it may be possible to use only one ground pin in some applications. The ground pins, 16 and 40, may be an integral part of the shield, 18, in the space between the boards, 11 and 12 as shown in Fig. 9.

## Claims

1. A device comprising:
at least one circuit board (12) having major surfaces (13, 14) with a signal pin hole (31), a ground pin hole (32), and a pattern of via holes (34-37) extending between the surfaces, and a DC ground plane (15), the via holes surrounding the signal pin hole and electrically connected to the DC ground plane; and
a ground pin (16) and signal pin (17) mounted within the ground pin hole and signal pin hole, respectively, and extending past at least one of the surfaces.

2. The device according to claim 1 wherein the circuit board comprises an additional ground pin hole (33) and ground pin (40) such that the ground pins are symmetric with respect to the signal pin.

3. The device according to claim 1 further comprising a conductive shield (18) surrounding at least a portion of the signal pin extending past the surface.

4. The device according to claim 3 wherein the shield forms a gap (6) with the surface of the board.

5. The device according to claim 1 wherein the device is adapted to propagate electrical signals having a frequency of up to 12 GHz.

6. The device according to claim 5 wherein the device is adapted to propagate signals of up to 10 GHz with an insertion loss no greater than -1.8 dB and a return loss of at least -15 dB.

7. The device according to claim 1 wherein there are at least 4 via holes surrounding the signal pin hole.

8. The device according to claim 1 further comprising an additional circuit (11) board spaced from the said at least one circuit board, the additional board also including ground pin and signal pin holes with the ground pin and signal pins extending from the at least one circuit board mounted therein.

9. The device according to claim 8 wherein the boards are spaced 254 microns or less from each other, and there is no conductive shield surrounding the signal pin in the space between the boards.

10. The device according to claim 9 wherein the boards are adapted to propagate an electrical signal of up to 10 GHz with an insertion loss no greater than -1.8 dB and a return loss of at least -15 dB.

11. The device according to claim 1 wherein the board is a multilayer board.

12. The device according to claim 11 wherein the board includes a substrate (22), an adhesive layer (21, 23), an RF ground plane (24), and an RF propagation layer (25).

13. The device according to claim 12 wherein the via holes are electrically coupled to the RF ground layer and the DC ground layer, and are insulated from the rest of the layers.

14. The device according to claim 1 wherein the via holes include side walls and conductive material formed on the side walls.
